Europäisches Patentamt

European Patent Office

Office européen des brevets

(11) Publication number: **0 026 114**
**B1**

(12) **EUROPEAN PATENT SPECIFICATION**

(45) Date of publication of patent specification: **25.01.89**

(51) Int. Cl.⁴: **H 03 H 9/64**

(21) Application number: **80303362.0**

(22) Date of filing: **24.09.80**

(54) **Surface acoustic wave device.**

(30) Priority: **25.09.79 JP 121933/79**

(43) Date of publication of application:
**01.04.81 Bulletin 81/13**

(45) Publication of the grant of the patent:
**25.01.89 Bulletin 89/04**

(84) Designated Contracting States:
**DE FR GB**

(56) References cited:
**FR-A-2 395 643**
**US-A-3 662 293**
**US-A-4 146 851**
**ELECTRONICS LETTERS, vol. 8, no. 12 15th**
**June 1972, pages 311-312 London, G.B. F.G.**
**MARSHALL:"New technique for the**
**suppression of trple-transit signals in surface-**
**acoustic-wave delay lines"**
**"New technique for the Suppression of triple-**
**transit signals in Surface-Acoustic-Wave Delay**
**Lines" ELECTRONICS LETTERS 15th June 1972**
**Vol. 8, No. 12, page 311-312, London**

(73) Proprietor: **FUJITSU LIMITED**
**1015, Kamikodanaka Nakahara-ku**
**Kawasaki-shi Kanagawa 211 (JP)**

(72) Inventor: **Iwamoto, Hisao**
**701, Kizuki Nakahara-ku**
**Kawasaki-shi Kanagawa 211 (JP)**
Inventor: **Wakatsuki, Noboru**
**1540-1-3-402, Nakanoshima Tama-ku**
**Kawasaki-shi Kanagawa 214 (JP)**

(74) Representative: **Allman, Peter John et al**
**MARKS AND CLERK Suite 301 Sunlight House**
**Quay Street**
**Manchester M3 3JY (GB)**

## Description

Background of the invention

The present invention relates to a surface acoustic wave device.

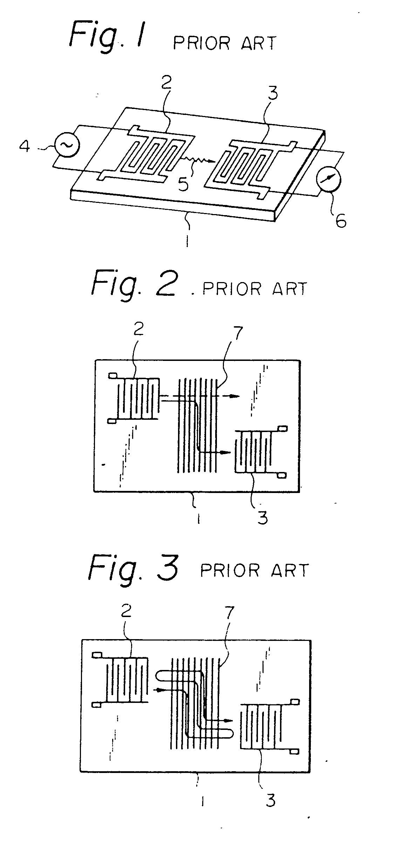

Recently, surface acoustic wave devices have been used as a band pass filter, a delay line, or the like. Some examples of conventional surface acoustic wave devices will be described below with reference to Figs. 1 through 3, of the accompanying drawings.

Fig. 1 illustrates a fundamental construction of a surface acoustic wave device serving as a band pass filter. This surface acoustic wave device comprises a substrate 1, which is made of a piezoelectric material, such as lithium niobate ($LiNbO_3$) or lithium tantalate ($LiTaO_3$), and is provided on the surface thereof with an input transducer 2 and an output transducer 3, each of which is composed of a pair of separated, interdigitated comb-shaped electrodes. When electrical signals from a generator 4 are applied to the electrodes of the input transducer 2, the latter emits surface acoustic waves 5, which are propagated to the output transducer 3 and then converted into other electrical signals which can be taken out from a load impedance 6. The electrodes of the input and output transducers can be designed in a variety of patterns, so as to provide various desired characteristics to the filter when electrical signals are converted into acoustic signals or vice versa. However, there is a problem in that the input transducer emits bulk waves, in addition to surface acoustic waves, which bulk waves are propagated through the body of the substrate to reach the output transducer, thereby adversely affecting the output characteristics of the latter.

In order to eliminate the above mentioned problem, in a conventional device, as illustrated in Fig. 2, the input transducer 2 and the output transducer 3 are arranged diagonally to each other, and a multistrip coupler 7 which includes a plurality of parallel conductors is provided between the input and output transducers. Energy of the surface acoustic waves emitted by the input transducer 2 is converted into electrical energy and then emitted again in the form of surface acoustic waves by the multistrip coupler 7, so that the path of propagation of the surface acoustic waves is changed, as indicated by a solid line. As a result, the effect of the bulk waves which are propagated, as indicated by a dotted arrow, is eliminated. In this case, however, there is a problem, as illustrated in Fig. 3, in that the surface acoustic waves are reflected by the output transducer 3, then propagated back to the input transducer 2 through the multistrip coupler 7, and are reflected again to reach the output transducer 3 through the multistrip coupler 7, thereby resulting in the occurrence of a so-called triple transit echo (hereinafter referred to as TTE), which adversely affects the characteristics of the filter.

In order to suppress such TTE, a conventional device has been proposed, as described in the article by F. G. Marshall entitled "New Technique For The Suppression of Triple Transit Signals In Surface-Acoustic Wave Delay Lines", published Electronics Letters, Volume 8, No. 12, 15th June 1972, pages 311—322, London, Great Britain. In the device described by Marshall, two identical transducers are provided on the side of a multistrip coupler remote from the input transducer. A first one of the two identical transducers acts as an output transducer and is arranged diagonally to the input transducer so as to be located in the same position as the transducer 3 of Figure 2. The second of the two identical transducers acts as a reflecting transducer and is located opposite the input transducer 2. The output and reflecting transducers are matched by circuits to which they are connected that are adjusted to have identical properties. The multistrip coupler is a 3dB coupler which splits the signal received from the input transducer into two equal signals in phase quadrature. Thus reflections from the output and reflecting transducers returned to the multistrip coupler have equal amplitudes and are in phase quadrature. The reflected signals are combined by the multistrip coupler into a single echo that emerges from the multistrip coupler opposite the output transducer and is absorbed by an acoustic absorber. Thus substantially no reflected wave reaches the input transducers and thus the TTE effect is effectively suppressed. Unfortunately the requirement that the output and reflecting transducers are matched makes it necessary to connect a dummy load to the reflecting transducer, the dummy load having identical properties to the output circuit connected to the output transducer. The provision of discrete components to form the dummy load is disadvantageous in that the device is increased in size and in cost due to an increased number of parts.

French Patent Specification No. FR—A—23 95 643 discloses a surface acoustic wave device comprising a reflector with no discrete components. The structure of this reflector is such however that the reflected wave is the result of simple reflection and there is no electrical regeneration of the wave. There is no electrical regeneration in the reflector because the elements of the reflector are either electrically isolated from each other, or are electrically interconnected such that electrical signals developed in the interconnected elements cancel each other out. As there is no electrical regeneration there is no need for discrete components to control the intensity of the regenerated wave, but in addition as there is no electrical regeneration the intensity of the reflected wave is low. To obtain a useful reflected wave intensity, the multistrip coupler must supply waves of equal intensity to the reflector and to the output transducer. The efficiency of transformation of the multistrip coupler is thus only 50%, as is the case with the device described by Marshall and referred to above.

It is an object of the present invention to provide a surface acoustic wave device comprising a reflecting transducer providing electrical regeneration and a high efficiency multistrip coupler in which the TTE can be effectively suppressed without the use of discrete electrical components.

According to the present invention, there is provided a surface acoustic wave device comprising:

a substrate made of piezoelectric material and having a plane surface for propagation of surface acoustic waves;

an input transducer formed on said substrate surface, for converting electrical signals into surface acoustic waves, said input transducer including a pair of interdigitated comb-shaped and weighted electrodes;

an output transducer formed on said substrate surface and arranged diagonally to said input transducer, for converting said surface acoustic waves into electrical signals, said output transducer including a pair of interdigitated comb-shaped and weighted electrodes;

a multistrip coupler formed on said substrate surface and interposed between said input and output transducers so as to be substantially orthogonal to the propagation direction of said surface acoustic waves, said coupler including a plurality of parallel conductors; and

a reflecting transducer formed on said substrate surface and arranged opposite to said input transducer with said multistrip coupler therebetween and parallel to said output transducer, for reflecting the surface acoustic waves received from said multistrip coupler, the reflecting transducer comprising a pair of interdigitated comb-shaped electrodes; characterised in that

said reflecting transducer consists exclusively of electrodes formed on said substrate surface, the multistrip coupler has a high efficiency such that the greater part of the surface acoustic wave emitted by the input transducer reaches the output transducer, said electrodes of said reflecting transducer are weighted and the number of conductors of said multistrip coupler is adjusted, so that the intensities and the frequency characteristics of the surface acoustic waves reflected by said output transducer and said reflecting transducer are equal to each other, and in that the device further comprises phase adjusting strips including a plurality of parallel conductors formed on said substrate surface and interposed between said reflecting transducer and said mutlistrip coupler, for adjusting the phase difference between the surface acoustic waves reflected by the output transducer and the reflecting transducer so as to be $(2n-1)\, \lambda/2$, where "$\lambda$" is a wavelength at a center frequency of said surface acoustic waves and "$n$" is a positive integral number, and each of said input and output transducers has a construction in which the pitch of the electrodes is $\lambda/4$ and the width of the electrodes is $\lambda/8$ and the said reflecting transducer has a construction in which the pitch of the electrodes is $\lambda/2$ and the width of the electrodes is $\lambda/4$.

Features of the present invention will be apparent from the description set forth below with reference to the accompanying drawings, in which:

Fig. 1 is a perspective view illustrating a conventional surface acoustic wave device;

Fig. 2 is a plan view illustrating a conventional surface acoustic wave device provided with a multistrip coupler;

Fig.. 3 illustrates the generation of the triple transit echo (TTE) in the surface acoustic wave device in Fig. 2;

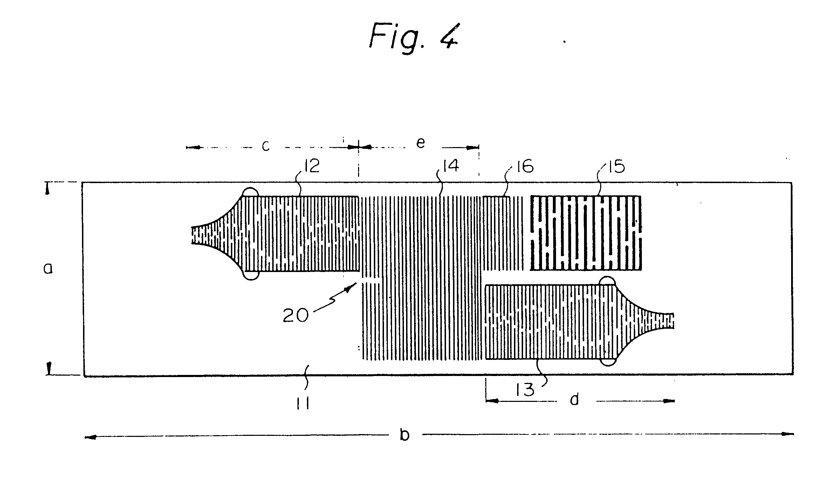

Fig. 4 is a plan view of an embodiment of a surface acoustic wave device according to the present invention;

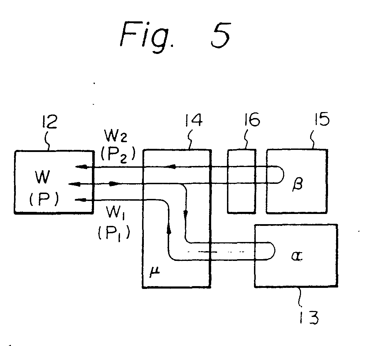

Fig. 5 is a view used to explain the suppression of the TTE in the embodiment in Fig. 4; and

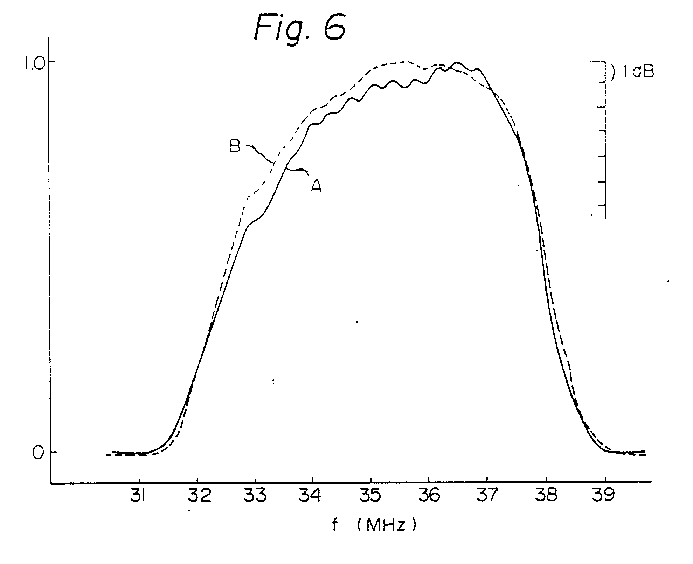

Fig. 6 is a graph illustrating frequency characteristics of the surface acoustic wave device according to the present invention illustrated in Fig. 4, in comparison with that of the conventional surface acoustic wave device illustrated in Fig. 2.

Description of the preferred embodiments

Referring to Fig. 4, an embodiment of a surface acoustic wave device according to the present invention comprises a substrate 11 which is made of a piezoelectric material. The substrate is provided on a plane surface thereof with an input transducer 12, an output transducer 13, a multistrip coupler 14, a reflecting transducer 15 and phase adjusting strips 16, which elements are formed by etching an aluminum layer of vapor deposition by means of a photolithographic technology. The input transducer 12 and the output transducer 13 are arranged diagonally to each other with the multistrip coupler 14 therebetween. Each of the input and output transducers includes a pair of interdigitated comb-shaped electrodes and has a construction in which the pitch (i.e. center-to-center spacing) of the electrodes is $\lambda/4$ and the width of the electrodes is $\lambda/8$, where $\lambda$ is a wavelength at the center frequency of the surface acoustic wave, and the electrodes are weighted to provide desired frequency characteristics. The multistrip coupler 14 is arranged so as to be substantially orthogonal to the propagation direction of said surface acoustic waves, and includes a plurality of parallel conductors. The reflecting transducer 15 is arranged opposite to the input transducer 12 with the multistrip coupler 14 therebetween and parallel to the output transducer 13. The reflecting transducer 15 includes a pair of interdigitated comb-shaped electrodes and has a construction in which the pitch of the electrodes is $\lambda/2$ and the width of the electrodes is $\lambda/4$ and the electrodes are weighted to provide desired frequency characteristics. The phase adjusting strips 16 include a plurality of parallel conductors and are interposed between the multistrip coupler 14 and the reflecting transducer 15.

The path of propagation of the greater part of the surface acoustic waves emitted by the input transducer 12 is caused to change by virtue of the multistrip coupler 14 and reaches the output transducer 13. However, the number of conductors of the multistrip coupler 14 is adjusted, so that not all of the surface acoustic waves emitted by the input transducer are caused to change their path of propagation, but a part thereof is allowed to go straight to reach the reflecting transducer 15 through the phase adjusting strips 16. Therefore, as illustrated in Fig. 5 the surface acoustic waves W emitted by the input transducer 12 are reflected by the output transducer 13 and the reflecting transducer 15, and both sets of reflected waves $W_1$ and $W_2$ are returned to the input transducer 12.

In order to suppress the above mentioned TTE, it is necessary that both sets of reflected waves $W_1$ and $W_2$ are cancelled by each other. For this purpose, the intensity (or the amount of reflection) of, and the phase difference between, the sets of reflected waves $W_1$ and $W_2$, must satisfy the requirements set forth below.

Firstly, the intensity of both sets of reflected waves $W_1$ and $W_2$ are defined as follows:

$$P_1 = 2\mu\alpha P$$
$$P_2 = 2(1-\mu)\beta P$$

where,

P: Intensity of the surface acoustic waves W emitted by the input transducer

$P_1$: Intensity at the input transducer of the reflected waves $W_1$ from the output transducer

$P_2$: Intensity at the input transducer of the reflected waves $W_2$ from the reflecting transducer

$\mu$: Efficiency of transformation of the multistrip coupler

$\alpha$: Reflection factor of the output transducer

$\beta$: Reflection factor of the reflecting transducer

The cancellation of the sets of reflected waves $W_1$ and $W_2$ by each other must meet the following requirement:

$$P_1 = P_2$$

$$\therefore \mu\alpha = (1-\mu)\beta$$

According to the present invention, the adjustment of the intensity of the sets of reflected waves $W_1$ and $W_2$ is achieved by weighting the electrodes of the reflecting transducer 15 and by adjusting the number of conductors of the multistrip coupler 14. The weighting of the electrodes of the reflecting transducer 15 results in the adjustment of the reflection factor $\beta$. The adjustment of the number of conductors of the multistrip coupler 14 results in the adjustment of the transformation efficiency $\mu$. The adjustment of the number of conductors of the multistrip coupler can be performed in the following manner. A number of conductors of the multistrip coupler which provide a transformation efficiency of 100% is preliminary formed, and then an appropriate number of conductors is cut by means of a laser, as indicated by the reference numeral 20 in Fig. 4, so that the desired transformation efficiency is attained. Therefore, without the use of a dummy load such as in the conventional device described above, the intensity $P_2$ of the reflected waves $W_2$ from the reflecting transducer 15 can be adjusted to be substantially equal to the intensity $P_1$ of the reflected waves $W_1$ from the output transducer 13.

Both the input transducer 12 and the output transducer 13 have constructions in which the pitch of electrodes is $\lambda/4$, so that reflection of the surface acoustic waves is suppressed as much as possible, and the reflecting transducer 15 has a construction in which the pitch of electrodes is $\lambda/2$, so that the amount of reflection is as great as possible.

Furthermore, the cancellation of the reflected sets of waves $W_1$ and $W_2$ by each other must meet the requirement that the phase difference between both sets of reflected waves is $(2n-1)\pi$, i.e. $(2n-1)\lambda/2$, where "n" is a positive integral number. For this purpose, the phase adjusting strips 16 are provided, by virtue of which the phase of the reflected waves $W_2$ from the reflecting transducer 15 can be appropriately adjusted. This adjustment of phase can be achieved by adjusting the number, width and the pitch of conductors of the strips 16, or by making the ends thereof to be short-circuited.

As stated above, the sets of reflected waves $W_1$ and $W_2$ are adjusted so that the intensity thereof are substantially equal to each other and the phase difference is $(2n-1)/\lambda/2$, resulting in the cancellation of the sets of reflected waves $W_1$ and $W_2$ by each other. As a result, the TTE can be suppressed, whereby the frequency characteristics of the surface acoustic wave filter can be improved.

Fig. 6 illustrates the frequency characteristic of the surface acoustic wave device according to the present invention illustrated in Fig. 4, in comparison with that of the conventional surface acoustic device illustrated in Fig. 2, each of which devices has a center frequency of 36 MHz and a frequency band of 7 MHz. The device according to the present invention is manufactured with the following conditions.

(1) General dimensions

$$a = 3,500\mu$$
$$b = 12,000\mu$$
$$c = 3,000\mu$$
$$d = 3,600\mu$$
$$e = 2,000\mu$$

(2) Input transducer 12

| | |
|---|---|
| Number of electrodes: | 130 |
| Pitch of electrodes: | 27 μ |
| Width of electrode: | 14 μ |
| Cross-width: | 1.5 mm |

(3) Output transducer 13

| | |
|---|---|
| Number of electrodes: | 140 |
| Pitch of electrodes: | 28 μ |
| Width of electrode: | 14 μ |
| Cross-width: | 1.5 mm |

(4) Multistrip coupler 14
    Number of conductors: 77

(110 conductors are preliminarily formed and 33 conductors are cut to adjust the transformation efficiency)

| | |
|---|---|
| Pitch of conductors: | 29 μ |
| Width of conductor: | 15 μ |
| Length: | 3.2 mm |

(5) Reflecting transducer 15

| | |
|---|---|
| Number of electrodes: | 60 |
| Pitch of electrodes: | 56 μ |
| Width of electrode: | 28 μ |
| Cross-width: | 1.5 mm |

(6) Phase adjusting strips 16

| | |
|---|---|
| Number of conductors: | 32 |
| Pitch of electrodes: | 28 μ |
| Width of electrodes: - | 14 μ |
| Length: | 1.5 mm |

In Fig. 6, the abscissa represents a frequency and the ordinate represents a response (in linear scale). A curve "A" (solid line) represents the characteristics of the conventional device, and a curve "B" (dotted line) represents the characteristics of the device according to the present invention. It will be understood from this figure that the conventional device produces ripples of about 0.36 dB, while the device according to the present invention produces ripples of 0.2 dB. This fact manifests the effect of suppressing the TTE.

As mentioned above, the present invention provides a surface acoustic wave device, in which the number of conductors of the multistrip coupler is adjusted and the electrodes of the reflecting transducer are weighted so that the frequency characteristics and the intensity of, and the phase difference between, the sets of reflected waves from the output transducer and the reflecting transducer are adjusted, whereby the TTE can be suppressed over a wide range of frequencies. Accordingly, a surface acoustic wave device having good frequency characteristics can be provided.

Furthermore, the device according to the present invention does not need a dummy load, and therefore requires few component parts. Accordingly, a surface acoustic wave device which is low in price and small in size can be provided.

It should be appreciated that the invention has been described above in detail with particular reference to the preferred embodiment thereof, but variations and modifications can be made thereto within the spirit and scope of the invention.

## Claims

1. A surface acoustic wave device comprising:
a substrate (11) made of piezoelectric material and having a plane surface for propagation of surface acoustic waves;
an input transducer (12) formed on said substrate surface, for converting electrical signals into surface acoustic waves, said input transducer including a pair of interdigitated comb-shaped and weighted electrodes;
an output transducer (13) formed on said substrate surface and arranged diagonally to said input transducer, for converting said surface acoustic waves into electrical signals, said output transducer including a pair of interdigitated comb-shaped and weighted electrodes;
a multistrip coupler (14) formed on said substrate surface and interposed between said input and output transducers so as to be substantially orthogonal to the propagation direction of said surface acoustic waves, said coupler including a plurality of parallel conductors; and
a reflecting transducer (15) formed on said substrate surface and arranged opposite to said input transducer with said multistrip coupler therebetween and parallel to said output transducer, for reflecting the surface acoustic waves received from said multistrip coupler, the reflecting transducer comprising a pair of interdigitated comb-shaped electrodes; characterised in that
said reflecting transducer consists exclusively of electrodes formed on said substrate surface, the multistrip coupler has a high efficiency such that the greater part of the surface acoustic wave emitted by the input transducer reaches the output transducer, said electrodes of said reflecting transducer (15) are weighted and the number of conductors of said multistrip coupler (14) is adjusted, so that the intensities and the frequency characteristics of the surface acoustic waves reflected by said output transducer and said reflecting transducer are equal to each other, and in that the device further comprises phase adjusting strips (16) including a plurality of parallel conductors formed on said substrate surface and interposed between said reflecting transducer (15) and said multistrip coupler (14), for adjusting the phase difference between the surface acoustic waves reflected by the output transducer and the reflecting transducer so as to be $(2n-1)\lambda/2$, where "$\lambda$" is a wavelength at a center frequency of said surface acoustic waves and "$n$" is a positive integral number, and each of said input and output transducers (12, 13) has a construction in which the pitch of the electrodes is $\lambda/4$ and the width of the electrodes is $\lambda/8$, and the said reflecting transducer has a construction in which the pitch of the electrodes is $\lambda/2$ and the width of the electrodes is $\lambda/4$.

2. A device according to claim 1, which has been manufactured by initially forming the conductors of said multistrip coupler (14) such that the coupler is 100 percent efficient, and then selectively cutting the conductors of said multistrip coupler so as to equalize the intensity of reflected surface acoustic waves reflected by said output transducer and by said reflecting transducer.

## Patentansprüche

1. Vorrichtung mit akkustischen Oberflächenwellen mit:

einem Substrat (11), das aus piezoelektrischem Material hergestellt ist und eine ebene Oberfläche zur Ausbreitung von akkustischen Oberflächenwellen hat;

einem Eingangswandler (12), der auf der genannten Substratoberfläche gebildet ist, zum Konvertieren elektrischer Signale in akkustische Oberflächenwellen, welcher genannte Eingangswandler ein Paar von ineinander verschachtelten kammförmigen und gewichteten Elektroden hat;

einem Ausgangswandler (13), der auf der genannten Substratoberfläche gebildet und diagonal zu dem genannten Eingangswandler angeordnet ist, zum Konvertieren der genannten akkustischen Oberflächenwellen in elektrische Signale, welcher genannte Ausgangswandler ein Paar von ineinander verschachtelten kammförmigen und gewichteten Elektroden hat;

einem Mehrfachstreifenkoppler (14), der auf der genannten Substratoberfläche gebildet und zwischen dem genannten Eingangswandler und dem genannten Ausgangswandler so angeordnet ist, daß er im wesentlichen orthogonal zur Ausbreitungsrichtung der genannten akkustischen Oberflächenwellen ist, welcher genannte Koppler eine Vielzahl von parallelen Leitern enthält; und

einem reflektierenden Wandler (15), der auf der genannten Substratoberfläche gebildet ist und gegenüber dem genannten Eingangswandler mit dem genannten Mehrfachstreifenkoppler dazwischen und parallel zu dem genannten Ausgangswandler angeordnet ist, zum Reflektieren der akkustischen Oberflächenwellen, die von dem genannten Mehrfachstreifenkoppler empfangen werden, wobei der reflektierende Wandler ein Paar von ineinander verschachtelten kammförmigen Elektroden aufweist; dadurch gekennzeichnet, daß

der genannte reflektierende Wandler ausschließlich aus Elektroden besteht, die auf der genannten Substratoberfläche gebildet sind, der Mehrfachstreifenkoppler einen so hohen Wirkungsgrad hat, daß der größere Teil der akkustischen Oberflächenwelle, die von dem Eingangswandler emittiert wird, den genannten Ausgangswandler erreicht, die genannten Elektroden des genannten reflektierenden Wandlers (15) gewichtet sind und die Zahl der Leiter des genannten Mehrfachstreifenkopplers (14) eingestellt ist, so daß die Intensitäten und die Frequenzcharakteristiken der akkustischen Oberflächenwellen, die von dem genannten Ausgangswandler und dem genannten reflektierenden Wandler reflektiert werden, zueinander gleich sind, und daß die Vorrichtung ferner Phaseneinstellstreifen (16) umfaßt, die eine Vielzahl von parallelen Leitern enthalten, die auf der genannten Substratoberfläche gebildet und zwischen dem genannten reflektierenden Wandler (15) und dem genannten Mehrfachstreifenkoppler (14) angeordnet sind, zum Einstellen der Phasendifferenz zwischen den akkustischen Oberflächenwellen, die von dem Ausgangswandler und dem reflektierenden Wandler reflektiert werden, um so zu $(2n-1)\lambda/2$ zu

werden, wobei "$\lambda$" eine Wellenlänge bei der Zentralfrequenz der genannten akkustischen Oberflächenwellen und "n" eine positive ganze Zahl ist, und jeder der genannten Eingangs- und Ausgangswandler (12, 13) einen Aufbau hat, bei dem die Schrittweite der Elektroden $\lambda/4$ und die Breite der Elektroden $\lambda/8$ ist, und der genannte reflektierende Wandler einen Aufbau hat, bei dem die Schrittweite der Elektroden $\lambda/2$ und die Breite der Elektroden $\lambda/4$ ist.

2. Vorrichtung nach Anspruch 1, welche hergestellt ist durch anfängliches Bilden der Leiter des genannten Mehrfachstreifenkopplers (14), so daß der Koppler 100% effizient ist, und anschließendes selektives Schneiden der Leiter des genannten Mehrfachstreifenkopplers, um so die Intensität der reflektierten akkustischen Oberflächenwellen auszugleichen, die von dem genannten Ausgangswandler und von dem genannten reflektierenden Wandler reflektiert werden.

**Revendications**

1. Un dispositif à ondes acoustiques de surface comprenant:

un substrat (11) en un matériau piézoélectrique et ayant une surface plane pour la propagation d'ondes acoustiques de surface;

un transducteur d'entrée (12) formé sur la surface du substrat, pour convertir des signaux électriques en ondes acoustiques de surface, ce transducteur d'entrée comprenant une pair d'électrodes en peigne interdigitées et pondérées;

un transducteur de sortie (13) formé sur la surface du substrat et disposé en diagonale par rapport au transducteur d'entrée, pour convertir les ondes acoustiques de surface en signaux électriques, ce transducteur de sortie comprenant une paire d'électrodes en peigne interdigitées et pondérées;

un coupleur multibande (14) formé sur la surface du substrat et intercalé entre les transducteurs d'entrée et de sortie, de façon à être pratiquement orthogonal à la direction de propagation des ondes acoustiques de surface, ce coupleur comprenant un ensemble de conducteurs parallèles; et

un transducteur réfléchissant (15) formé sur la surface du substrat et disposé face au transducteur d'entrée, avec le coupleur multibande intercalé entre aux, et orienté parallèlement au transducteur de sortie, pour réfléchir les ondes acoustiques de surface qui sont reçues à partir du coupleur multibande, le transducteur réfléchissant comprenant une paire d'électrodes en peigne interdigitées; caractérisé en ce que:

le transducteur réfléchissant consiste exclusivement en électrodes formées sur la surface du substrat, le coupleur multibande a un rendement élevé de façon que la majeure partie de l'onde acoustique de surface qui est émise par le transducteur d'entrée atteigne le transducteur de sortie, les électrodes du transducteur réfléchissant (15) sont pondérées, et le nombre de conducteurs du coupleur multibande (14) est réglé, de façon que les intensités et les caractéristiques de fréquence des ondes acoustiques de surface qui sont réfléchies par le transducteur de sortie et par le transducteur réfléchissant soient mutuellement égales, et en ce que le dispositif comprend en outre des bandes de réglage de phase (16) comprenant un ensemble de conducteurs parallèles formés sur la surface du substrat et intercalés entre le transducteur réfléchissant (15) et le coupleur multibande (14), pour régler la différence de phase entre les ondes acoustiques de surface qui sont réfléchies par le transducteur de sortie et par le transducteur réfléchissant, de façon qu'elle soit égale à (2n−1)λ/2, en désignant par "λ" une longueur d'onde à une fréquence centrale des ondes acoustiques de surface et par "n" un nombre entier positif, et chacun des transducteurs d'entrée et de sortie (12, 13) a une structure dans laquelle le pas des électrodes est λ/4 et la largeur des électrodes est λ/8, et le transducteur réfléchissant a une structure dans laquelle le pas des électrodes est λ/2 et la largeur des électrodes est λ/4.

2. Un dispositif selon la revendication 1, qui a été fabriqué en formant initialement les conducteurs du coupleur multibande (14) de façon que le coupleur ait un rendement de 100%, et en coupant ensuite sélectivement les conducteurs du coupleur multibande afin d'égaliser l'intensité des ondes acoustiques de surface qui sont réfléchies par le transducteur de sortie et par le transducteur réfléchissant.

Fig. 1 PRIOR ART

Fig. 2 . PRIOR ART

Fig. 3 PRIOR ART

Fig. 4

# Fig. 5

EP 0 026 114 B1

## Fig. 6

) 1 dB

f (MHz)